# DEMANDE DE BREVET EUROPEEN

(11) **EP 2 581 987 A1**
(43) Date de publication de la demande: **17.04.2013**
(21) Numéro de dépôt: 12306236.6
(22) Date de dépôt: 10.10.2012
(51) Int. Cl.: H01R 12/58, H01R 12/62

(54) **Dispositif d'interconnexion électrique d'au moins deux cartes électroniques**

(30) Priorité: 13.10.2011 FR 1159250
(71) Demandeur: Valeo Systèmes de Contrôle Moteur, 95800 Cergy Saint Christophe (FR)
(72) Inventeur: Schwartz, Christian, 78400 CHATOU (FR); Lefevre, Bruno, 91210 DRAVEIL (FR); Plaideau, Michel, 95590 PRESLES (FR); Mousset, Jean-Luc, 27140 BAZINCOURT SUR EPTE (FR)
(74) Mandataire: Cardon, Nicolas

(57) **Abrégé**

Dispositif (5) d'interconnexion électrique d'au moins deux cartes électroniques (2, 3), le dispositif (5) comprenant :
- un support (6) présentant au moins une portion flexible,
- des pistes électriquement conductrices portées par le support (6), et
- un système (10) de connexion électrique du dispositif (5) à chaque carte électronique (2, 3), le système (10) comprenant une pluralité de pattes (13, 14) de forme courbe.

## Description

La présente invention concerne l'interconnexion électrique d'au moins deux cartes électroniques. Ces cartes électroniques sont par exemple utilisées dans l'automobile pour la commande d'actionneurs.

Il est connu d'interconnecter deux cartes électroniques à l'aide d'un dispositif comprenant un support flexible et des pattes planes. La connexion du dispositif à chaque carte se fait en disposant des pattes planes parallèlement au plan de la carte électronique et en les amenant au contact de ladite carte. Un appui sur ces pattes est ensuite effectué à l'aide d'une barre préalablement chauffée. Il est relativement contraignant de s'assurer qu'un contact satisfaisant existe avant application de la barre. En outre, la connexion obtenue entre les pattes et la carte électronique peut présenter des défauts.

Le brevet US 4 085 502 divulgue un dispositif d'interconnexion d'un connecteur avec un circuit électronique.

Il existe un besoin pour permettre d'interconnecter des cartes électroniques à l'aide d'un dispositif d'interconnexion électrique de façon simple, peu coûteuse et efficace, cette interconnexion permettant des mouvements relatifs d'une carte électronique par rapport à l'autre.

L'invention a pour but de répondre à ce besoin et elle y parvient, selon l'un de ses aspects, à l'aide d'un dispositif d'interconnexion électrique d'au moins deux cartes électroniques, le dispositif comprenant :
- un support présentant au moins une portion flexible,
- des pistes électriquement conductrices portées par le support, et
- un système de connexion électrique du dispositif à chaque carte électronique, le système de connexion électrique comportant une pluralité de pattes de forme courbe.

De par la portion flexible du support, un pivotement d'une carte électronique par rapport à l'autre est rendu possible. Au sens de la présente invention, il faut comprendre par « flexible » la propriété qu' ont certains matériaux de se déformer sans subir de rupture mécanique.

La forme courbe des pattes peut leur permettre d'être reçues dans des trous ménagés dans les cartes électroniques. Grâce à la partie courbée des pattes, le système de connexion peut être moins sensible au déplacement par rapport à la carte électronique du support du dispositif lors de la connexion du dispositif à ladite carte. Ce déplacement peut être provoqué par une réaction du support due aux conditions thermiques dans lesquelles s'effectue la connexion, par exemple lorsque la connexion est effectuée grâce à la chaleur dégagée par un four de refusion.

Le système de connexion peut être relié électriquement aux pistes du support.

Les pattes peuvent être réalisées en un matériau électriquement conducteur. Ces pattes peuvent être identiques ou de types différents.

Le système de connexion peut être mécaniquement solidaire du support. Les pattes peuvent être ainsi être solidarisées, ou encore rigidement couplées, avec le support. Les pattes sont par exemple solidarisées au support lors de la fabrication du dispositif.

Les pattes et les pistes électriquement conductrices du support peuvent être réalisées d'une seule pièce, les pattes définissant alors par exemple un prolongement de pistes électriquement conductrices du support.

Les pattes sont avantageusement formées par une portion proximale et une portion distale faisant un angle entre elles. Cet angle est par exemple de l'ordre de 90°.

La portion distale peut comprendre, étant notamment formée par, une première zone à proximité de la portion proximale et une deuxième zone à proximité de l'extrémité libre de la patte. La première zone présente avantageusement une largeur supérieure à celle de la deuxième zone. On désigne par « largeur d'une patte » sa plus grande dimension mesurée dans un plan perpendiculaire à l'axe selon lequel la patte s'étend.

Le passage de la première à la deuxième zone est par exemple formé par un épaulement. Lorsque la patte est montée dans un trou de la carte électronique, seule la deuxième zone de la portion distale peut avoir une largeur lui permettant d'être reçue dans ledit trou, l'épaulement venant alors en butée contre une face de la carte électronique. La première zone de la portion distale permet alors de maintenir le support du dispositif à une hauteur différente de celle de la carte électronique, lors et après les opérations de connexion.

Lorsque les pattes sont de types différents, le système de connexion peut comprendre deux ou plusieurs types de pattes différents. Les types de pattes peuvent différer par les dimensions et/ou la forme des pattes.

Les pattes peuvent permettre de connecter électriquement les pistes du support aux cartes. Le cas échéant, la connexion mécanique du dispositif aux cartes peut être effectuée grâce aux pattes. En variante, la connexion mécanique du dispositif aux cartes est assurée au moins en partie autrement que via les pattes.

Le support peut comporter au moins un trou permettant le positionnement du dispositif vis-à-vis d'au moins une carte électronique. Le support comprend par exemple entre un et dix trous, par exemple quatre. Un même nombre de trous peut être dédié au positionnement du dispositif vis-à-vis de chaque carte électronique. Ces trous sont par exemple traversants, débouchant alors sur des surfaces opposées du support.

Chaque trou peut former une mire, ce qui peut être avantageux lorsque le dispositif est posé sur chaque carte électronique en utilisant des outils preneur-poseur (*pick and place* en anglais).

Le support peut se présenter sous la forme d'une plaque. On désigne au sens de la présente invention par « plaque » un support ayant une épaisseur très inférieure à sa plus petite autre dimension, à savoir sa largeur ou sa longueur. Le rapport entre la plus petite autre dimension et l'épaisseur d'un tel support est par exemple supérieur à dix, notamment à cent. La plaque peut avoir toute forme, par exemple circulaire ou polygonale, notamment carrée ou rectangulaire.

Le système de connexion peut comporter deux rangées de pattes, chaque rangée de pattes étant disposée le long d'une bordure de la plaque. D'une bordure à l'autre, un même nombre de pattes peut ou non être disposé le long de ladite bordure de la plaque. Seuls deux bordures de la plaque peuvent être pourvues de pattes. En variante, un nombre plus élevé de bordures pourvues de pattes est possible.

Les bordures le long desquelles est disposée une rangée peuvent être des largeurs ou des longueurs de la plaque.

Lorsque des pattes selon deux types différents sont prévues, chaque rangée peut comporter une alternance de pattes d'un premier type et de pattes d'un second type, le second type étant différent du premier type. Cette disposition de pattes de types différents en alternance peut permettre d'augmenter le nombre de pattes le long de la bordure par rapport à l'utilisation de pattes d'un même type uniquement. Le pas entre deux pattes consécutives disposées le long de la bordure peut ainsi être réduit.

Le support peut être réalisé d'un seul tenant, c'est-à-dire que le support peut ne pas comprendre différents éléments articulés entre eux ou encore présentant un degré de liberté entre eux.

Le dispositif peut être configuré pour que chaque piste puisse acheminer un courant allant jusqu'à quelques Ampères.

L'invention a encore pour objet, selon un autre de ses aspects, un ensemble, comprenant :
- une première et une deuxième carte électronique, et
- un dispositif tel que défini ci-dessus, interconnectant électriquement lesdites cartes.

La première et la deuxième carte électronique peuvent porter des composants électroniques. Il s'agit par exemple de composants électroniques tels que l'un au moins des éléments suivants : au moins un condensateur, au moins un transformateur, au moins un microcontrôleur ou microprocesseur, au moins un capteur, notamment un capteur de position, par exemple un capteur à effet Hall. Des composants de puissance peuvent également ou en variante être disposés sur l'une au moins des cartes, ces composants étant par exemple des interrupteurs de puissance.

L'invention a encore pour objet, selon un autre de ses aspects, un procédé de réalisation d'au moins deux cartes électroniques interconnectées électriquement, comprenant les étapes de :
- disposer d'un substrat portant des pistes électriquement conductrices, le substrat étant formé par au moins deux parties reliées par une liaison mécanique, notamment des ponts de matière,
- disposer des composants électroniques et le dispositif d'interconnexion défini ci-dessus sur le substrat de telle sorte que ledit dispositif interconnecte électriquement les deux parties du substrat, et
- séparer les parties du substrat en supprimant la liaison mécanique, notamment en rompant les ponts de matière, de manière à ce que lesdites parties forment des cartes électroniques indépendantes.

Les composants électroniques disposés peuvent être des composants montés en surface (CMS) et l'étape de disposition de ces composants sur le substrat peut être réalisée avec des outils adaptés à de tels composants, comme des outils preneur-poseur (*pick and place* en anglais).

Les composants électroniques et le dispositif d'interconnexion peuvent être disposés sur le substrat à l'aide des mêmes outils, par exemple des outils preneur-poseur.

La connexion des composants électroniques sur le substrat peut être obtenue à l'aide de la chaleur dégagée par un four de refusion. Le dispositif d'interconnexion peut être connecté à chaque partie du substrat de la même façon que les composants électroniques sont connectés au substrat, par exemple grâce à la chaleur dégagée par un four de refusion.

La mise en place et/ou la connexion des composants électroniques au substrat et la mise en place et/ou la connexion du dispositif au substrat peuvent alors être effectuées à l'aide des mêmes outils ce qui peut simplifier le procédé et rendre plus rapide sa mise en oeuvre.

Le dispositif d'interconnexion est avantageusement mis en place avant que les deux parties du substrat ne soient séparées.

Lorsque les deux parties sont séparées, ces dernières peuvent être interconnectées électriquement, et le cas échéant mécaniquement, uniquement ou non via le dispositif.

Les composants électroniques montés sur le substrat peuvent présenter ensemble une puissance électrique comprise entre 0 et 100W. Cette valeur correspond à la somme des puissances électriques des composants montés sur le substrat.

Les composants électroniques peuvent être autres que des composants électroluminescents.

Tout ou partie des caractéristiques présentées ci-dessus en rapport avec le dispositif ou l'ensemble concernent également le procédé, et réciproquement.

L'invention pourra être mieux comprise à la lecture de la description qui va suivre d'un exemple non limitatif de mise en oeuvre de celle-ci et à l'examen du dessin annexé sur lequel :
- la figure 1 représente un ensemble comprenant deux cartes électroniques interconnectées électriquement par un dispositif selon un exemple de mise en oeuvre de l'invention,
- les figures 2 et 3 représentent de façon isolée le dispositif de la figure 1,
- les figures 4 et 5 représentent différentes étapes lors de la réalisation de deux cartes électroniques interconnectées électriquement par le dispositif et,
- la figure 6 représente un détail d'une patte du dispositif des figures 2 et 3.

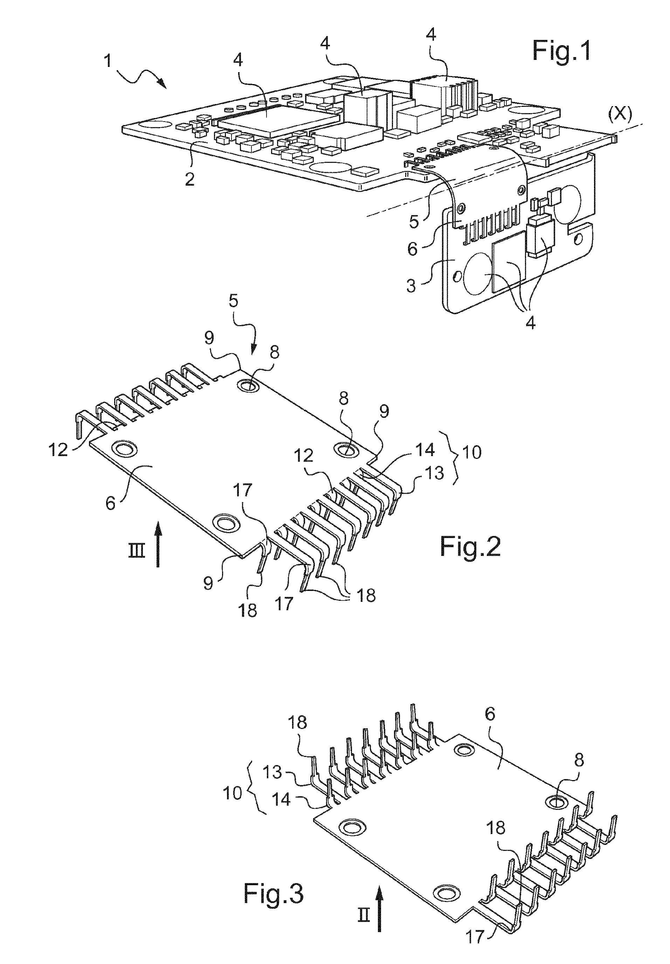

On va maintenant décrire un exemple de mise en oeuvre de l'invention. On a représenté à la figure 1 un ensemble 1 comprenant deux cartes électroniques 2 et 3. Ces cartes électroniques comprennent par exemple un substrat réalisé en epoxy avec des fibres de verre et portant des pistes électriquement conductrices.

Des composants électroniques 4 sont implantés sur chacune de ces cartes électroniques 2 ou 3. Ces composants électroniques 4 peuvent être de types différents. Il s'agit par exemple de composants tels qu'un ou plusieurs microcontrôleurs, un ou plusieurs transformateurs et/ou un ou plusieurs condensateurs. La puissance électrique totale au niveau de chaque carte électronique 2 ou 3 est par exemple comprise entre 0 et plusieurs kW, étant notamment de l'ordre de 100W.

Comme on peut le voir sur la figure 1, les cartes électroniques 2 et 3 peuvent être de dimensions différentes, l'une des cartes 2 étant par exemple sensiblement plus grande que l'autre carte 3.

Les deux cartes électroniques 2 et 3 sont interconnectées électriquement par un dispositif 5 qui va maintenant être décrit, notamment en référence aux figures 2 et 3. Ce dispositif 5 comprend un support 6 se présentant dans l'exemple considéré sous la forme d'une plaque. La longueur *L* du support 6 et sa largeur *l*, qui sont ici sensiblement égales, sont très supérieures à son épaisseur *e*. Le rapport entre *l* et *e* est par exemple compris entre 10 et 100. Les dimensions en mm du support 6 peuvent être les suivantes: 30x20x0,3.

Le support 6 porte des pistes électriquement conductrices non représentées sur les figures. Dans l'exemple de la figure 1, le support 6 est entièrement flexible, étant par exemple réalisé en polyimide. La flexibilité du support 6 lui permet notamment d'être incurvé autour d'un axe rectiligne X.

L'invention n'est cependant pas limitée à un dispositif 5 ayant un support 6 entièrement flexible. Dans des variantes non illustrées, des renforts peuvent être rapportés sur le matériau flexible pour rigidifier des parties du support 6. Les renforts peuvent être disposés de manière à ce que seule une portion du support 6 s'étendant le long d'un axe rectiligne soit flexible.

La flexibilité du support 6 peut être obtenue à l'aide d'un matériau élastiquement déformable.

Des trous traversants 8 sont par ailleurs ménagés dans le support 6 dans l'exemple considéré. Le support 6 a par exemple une forme sensiblement carrée et les trous traversants 8 peuvent alors être ménagés à proximité des coins 9 du support 6. Ces trous peuvent être de même taille et présenter un contour circulaire. Le rôle de ces trous sera explicité par la suite.

Comme représenté sur les figures 2 et 3, le dispositif 5 comprend un système de connexion 10 à chaque carte électronique 2 ou 3. Le système de connexion 10 se présente dans l'exemple considéré sous la forme d'une pluralité de pattes faisant saillie au-delà du support 6. Dans l'exemple décrit, des pattes sont disposées le long de deux bordures opposées 12 du support 6. Toujours dans l'exemple décrit, deux types différents de pattes 13 et 14 sont prévus et, le long de deux bordures opposées 12, on trouve une alternance de pattes 13 d'un premier type et de pattes 14 d'un deuxième type. Une patte 14 succède ainsi à une patte 13 le long de la bordure 12 et vice versa.

Comme on peut le voir sur la figure 2 ou 3, les pattes 13 ou 14 présentent une forme coudée. Chaque patte 13 ou 14 comporte une portion proximale s'étendant depuis le support 6 jusqu'au coude 17 et une portion distale s'étendant depuis le coude 17 jusqu'à l'extrémité libre 18 de la patte 13 ou 14.

Les pattes 13 peuvent différer des pattes 14 par leur(s) dimension(s) et/ou leur forme. Dans l'exemple considéré, chaque patte 14 présente une portion proximale plus courte que chaque patte 13. Les portions distales des pattes 13 et 14 peuvent être de même longueur et, le cas échéant, de même forme.

Pour chaque patte 13 et/ou chaque patte 14, la portion proximale peut comprendre une première zone 30 s'étendant depuis le coude 17 et une deuxième zone 31 s'étendant depuis l'extrémité libre 18 de la patte 13 ou 14. La première zone 30 peut présenter une largeur supérieure *l1* à celle *l2* de la deuxième zone 31, les zones 30 et 31 étant alors reliées entre elles par un épaulement 32 dont le rôle sera expliqué ci-après.

L'extrémité libre 18 de chaque patte 13 ou 14 peut être ou non effilée.

Les pattes 13 ou 14 sont réalisées en un matériau électriquement conducteur et la portion proximale de chaque patte 13 ou 14 au niveau du support 6 peut être raccordée à une piste électriquement conductrice du support 6.

Lors de la connexion du dispositif 5 à la carte électronique 2 et à la carte électronique 3, les extrémités libres 18 des pattes 13 ou 14 sont par exemple introduites dans des trous ménagés dans le substrat d'une des cartes électroniques 2 ou 3. Seule la deuxième zone 31 de la portion distale de chaque patte peut présenter des dimensions permettant son passage dans ce trou traversant. L'épaulement 32 peut alors venir en butée contre une face du substrat de la carte électronique 2 ou 3. Une soudure ou brasure peut alors être effectuée pour connecter électriquement et, le cas échéant mécaniquement, chaque patte 13 ou 14 à la carte électronique 2 ou 3.

D'autres modes de connexion sont bien entendus possibles.

Lors de la connexion, les trous traversants 8 ménagés dans le support 6 servent de mire pour s'assurer d'un bon positionnement du dispositif 5 par rapport aux cartes électroniques 2 et 3 avant connexion, ce qui peut être nécessaire avec l'utilisation d'outils preneur-poseur (*pick and place* en anglais).

Comme on peut le voir sur la figure 1, une fois les cartes électroniques 2 et 3 interconnectées électriquement par le dispositif 5, un mouvement relatif, notamment une rotation, d'une des cartes électroniques par rapport à l'autre est possible, sans que cela ne dégrade l'interconnexion réalisée.

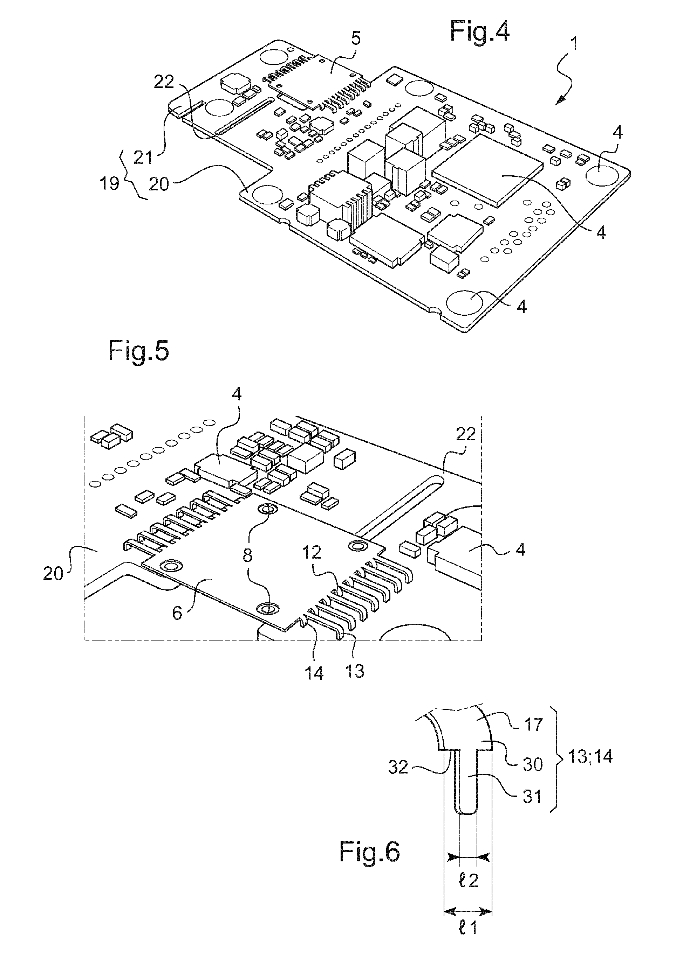

On va maintenant décrire en référence aux figures 4 et 5 un exemple de procédé de réalisation d'un ensemble 1 selon l'invention.

Lors d'une première étape représentée à la figure 4, des composants électroniques 4 sont montées sur un substrat 19 portant des pistes électriquement conductrices. Dans l'exemple considéré, ce substrat 19 est formé par deux parties 20 et 21 de taille différente et reliées mécaniquement entre elles par des ponts de matière 22. Ces composants 4 sont par exemple disposés à l'aide d'un ou plusieurs outils preneur-poseur.

Le dispositif 5 peut alors être disposé sur le substrat 19 à cheval sur les parties 20 et 21, de manière à interconnecter électriquement les deux parties 20 et 21.

Une fois le dispositif 5 et les composants 4 en place, les ponts de matière 22 peuvent être rompus, de manière à pouvoir déplacer l'une des parties 20 par rapport à l'autre partie 21, chaque partie 20 ou 21 formant alors une carte électronique 2 ou 3 indépendante et interconnectée électriquement à l'autre carte électronique à l'aide du dispositif 5.

L'invention n'est pas limitée aux exemples qui viennent d'être décrits.

Un nombre différent de types de pattes peut être prévu pour le système de connexion. Trois ou plus types de pattes différents peuvent alterner le long d'une bordure de la plaque.

L'expression « comportant un » doit être comprise comme signifiant « comportant au moins un », sauf lorsque le contraire est spécifié.

## Revendications

1. Dispositif (5) d'interconnexion électrique d'au moins deux cartes électroniques (2, 3), le dispositif (5) comprenant :
- un support (6) présentant au moins une portion flexible,
- des pistes électriquement conductrices portées par le support (6), et
- un système (10) de connexion électrique du dispositif (5) à chaque carte électronique (2, 3), le système (10) comprenant une pluralité de pattes (13, 14) de forme courbe.

2. Dispositif selon la revendication 1, les pattes (13, 14) comprenant une portion distale et une portion proximale faisant un angle entre elles.

3. Dispositif selon la revendication 2, la portion distale comprenant une première zone (30) à proximité de la portion proximale et une deuxième zone (31) à proximité de l'extrémité libre (18) de la patte (13, 14), la première zone (30) présentant une largeur (11) supérieure à celle (12) de la deuxième zone (31).

4. Dispositif selon la revendication 3, la première zone (30) étant reliée à la deuxième zone (31) via un épaulement (32).

5. Dispositif selon l'une des revendications précédentes, le support (6) comportant au moins un trou (8) permettant le positionnement du dispositif (5) vis-à-vis d'au moins une carte électronique (2, 3).

6. Dispositif selon l'une quelconque des revendications précédentes, le support (6) se présentant sous la forme d'une plaque.

7. Dispositif selon la revendication 6, le système de fixation (10) comportant deux rangées de pattes (13, 14), chaque rangée étant disposée le long d'une bordure (12) de la plaque.

8. Dispositif selon la revendication 7, chaque rangée comportant une alternance de pattes (13) d'un premier type et de pattes (14) d'un second type, le second type étant différent du premier type.

9. Dispositif selon l'une quelconque des revendications précédentes, les pattes (13, 14) étant rigidement couplées au support (6).

10. Ensemble (1), comprenant :
- une première (2) et une deuxième (3) carte électronique,
- un dispositif (5) selon l'une quelconque des revendications 1 à 9, interconnectant électriquement lesdites cartes (2, 3).

11. Ensemble selon la revendication 10, les cartes (2, 3) étant également interconnectées mécaniquement à l'aide du dispositif (5).

12. Procédé de réalisation d'au moins deux cartes électroniques (2, 3) interconnectées électriquement, comprenant les étapes de :
- disposer d'un substrat (19) portant des pistes électriquement conductrices, le substrat (19) étant formé par au moins deux parties (20, 21) reliées par une liaison mécanique (22) entre elles,
- disposer des composants électroniques (4) et le dispositif d'interconnexion (5) selon l'une quelconque des revendications 1 à 8 sur le substrat de telle sorte que le dispositif (5) interconnecte électriquement les deux parties (20, 21) du substrat (19), et
- séparer les parties (20, 21) du substrat en supprimant la liaison mécanique (22), de manière à ce que lesdites parties (20, 21) forment des cartes électroniques (2, 3).

13. Procédé selon la revendication 12, dans lequel les composants électroniques sont des composants montés en surface (CMS) et dans lequel l'étape de disposition de ces composants sur le substrat est réalisée à l'aide d'au moins un outil preneur-poseur.
